(19) Europäisches Patentamt
European Patent Office
Office européen des brevets

(11) Publication number: **0 297 051 A2**

# (12) EUROPEAN PATENT APPLICATION

(21) Application number: **88810421.3**

(22) Date of filing: **20.06.88**

(51) Int. Cl.[4]: **G 03 C 1/68**
G 03 F 7/10

(30) Priority: **25.06.87 GB 8714864**

(43) Date of publication of application:
**28.12.88 Bulletin 88/52**

(84) Designated Contracting States:
**BE CH DE FR GB IT LI NL**

(71) Applicant: **CIBA-GEIGY AG**
**Klybeckstrasse 141**
**CH-4002 Basel (CH)**

(72) Inventor: **Cawse, John Leslie**
**Old Barn Cottage Rainow**
**Macclesfield Cheshire SK10 5TY (GB)**

**Harris, Philip James**
**44 Oak Road Cheadle**
**Stockport Cheshire SK8 1EJ (GB)**

**Cwykla, Michael Veto**
**9 Huntley Road**
**Higher Crumpsall Manchester M86FJ (GB)**

## (54) Photopolymerisable composition.

(57) A photopolymerisable composition which comprises a water-soluble non-volatile ethylenically unsaturated monomer and a combination of a compound of the formula

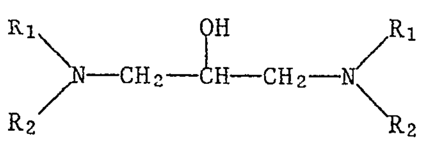

(1)

where $R_1$ is hydrogen or an alkyl group having 1 to 4 carbon atoms or a group of the formula

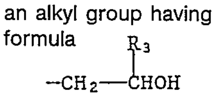

(2)

where $R_3$ is hydrogen or an alkyl group having 1 to 4 carbon atoms and $R_2$ is also a group of formula (2) and a dye, which combination on exposure to light is capable of initiating free radical polymerisation of said ethylenically unsaturated monomer.

EP 0 297 051 A2

## Description

### Photopolymerisable Composition

This invention relates to novel photopolymerisable compositions and in particular to photopolymerisable compositions which are of use in the production of volume holograms.

A large number of photopolymerisable systems are known wherein under the action of light a polymer is formed from a monomer or a mixture of monomers. Photopolymerisable materials have been used to provide raised images and in the production of photoresists.

A review of photopolymerisables processes is set forth in Chapter X of 'Imaging Systems' by Jacobson and Jacobson, John Wiley and Sons N.Y., pages 181-222 (1976). Dye-sensitized photopolymerisation is also discussed in this chapter.

In the well-known book 'Light-Sensitive Systems' by J. Kosar, John Wiley and Sons (1965) in Chapter 5 there are discussed various photopolymerisation processes. On pages 184-187 of this book there is a section on photo reducible dyes. It states on these pages that it has been well-known for many years that certain dyes will in the presence of electron donors (i.e. reducing agents) undergo reduction to their leuco form when illuminated by light. The article states that the reduced dye then reacts with ambient oxygen to produce free radicals which can initiate polymerisation of a polymerisable monomer. However it is now thought that no reaction with oxygen is required to produce free radicals. In the patent literature triethanolamine is often quoted in the examples as a reducing agent for use in such a system. For example it is used in Examples 1 and 2 of US 4,173,474.

However it has been found that in photopolymerisable systems which comprise a photo reducible dye together with a polymerisation initiating agent that the initiator is often unstable as it is a volatile compound or it is not reactive after coating and drying in a layered assembly.

It has now been found that certain hydroxyalkylamines can be used as polymerisation initiating agents as radical sites can be formed on them by light-exposed sensitizing dyes. Such radical sites then act to initiate polymerisation of an ethylenically unsaturated monomer.

Therefore according to a first feature of the present invention there is provided a photopolymerisable composition which comprises a water-soluble non-volatile ethylenically unsaturated monomer and a combination of a compound of formula

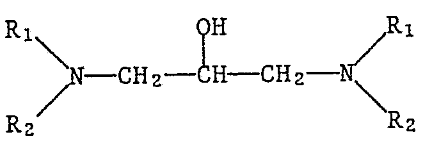

(1)

where $R_1$ is hydrogen or an alkyl group having 1 to 4 carbon atoms or a group of the formula

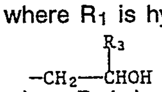

(2)

where $R_3$ is hydrogen or an alkyl group having 1 to 4 carbon atoms and $R_2$ is also a group of formula (2) with a sensitising dye, which combination on exposure to light is capable of initiating free radical polymerisation of said ethylenically unsaturated monomer.

The preferred compounds of formula (1) are compound A of the formula

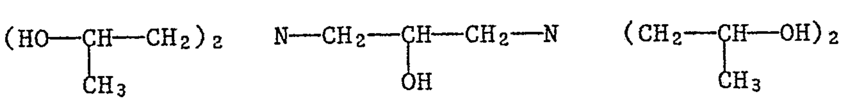

,

Compound B of the formula

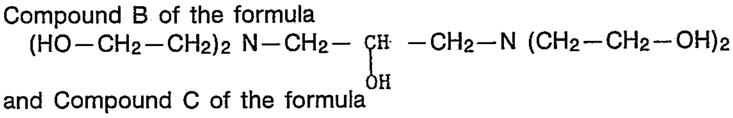

,

and Compound C of the formula

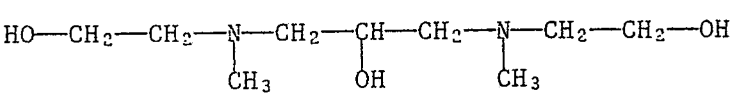

.

The compounds of formula (1) may be prepared by the reaction between an ethanolamine and

epichlorhydrin i.e. in the case of compound A:

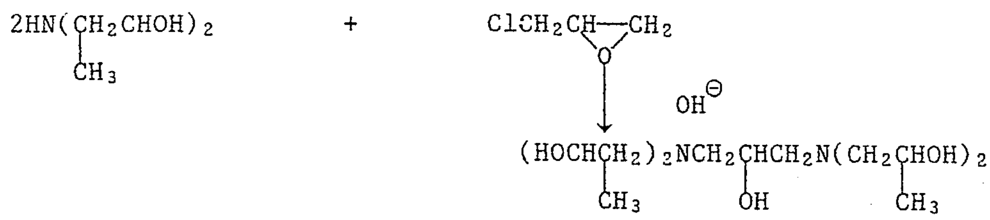


The compounds thus formed are colourless, viscous, non-volatile liquids, readily soluble is aqueous coating compositions.

Compounds of the formula (1) are described in for example, JACS, Volume 66, 1944, 880.

According to a second feature of the present invention there is provided the use of a compound of formula (1) as a polymerisation initiating agent in combination with a sensitising dye.

The preferred ethylenically unsaturated monomers for use in the present invention are the metal salts of acrylic or methacrylic acids. The preferred salts are lithium, sodium, potassium, barium, lead, zinc or magnesium acrylate. The most preferred salts are lithium or zinc acrylate.

A mixture of the metal acrylates may be used or mixtures of a metal acrylate and another ethylenically unsaturated monomer such as acrylamide, methacrylamide, N-hydroxymethylacrylamide, methylenebisacrylamide. Also esters of acrylic and methacrylic acids having low volatility may also be used, for example pentaerythritol, tetraacrylate, trimethylolpropane trimethacrylate and polybutanediol diacrylate.

The sensitising dye capable of initiating free radical polymerisation of the ethylenically unsaturated monomer on exposure in combination with any compound of formula (1) to light may be one of the dyes mentioned in the references hereinbefore set forth.

Suitable dyes include riboflavin, Rose Bengal, erythrosin and eosin. However the preferred dyes are Methylene Blue and the so-called New Methylene Blue, the latter dye being the most preferred dye.

Combinations of dyes may be used and in particular Methylene Blue or New Methylene Blue together with a dye which will absorb light not absorbed by either of these dyes.

According to a third aspect of the present invention there is provided an assembly for the preparation of a hologram which comprises a transparent supporting base on which is coated a photopolymerisable composition as just defined which has been dispersed in a hydrophilic water swellable binder.

A particularly useful binder is gelatin. Other useful binders which may be used alone or preferably in admixture with gelatin are those generally used in coating procedures of photographic materials and include albumin, casein, cellulose derivatives such as hydroxyethyl cellulose and carboxymethyl cellulose, polyvinyl alcohol, polyvinyl pyrrolidone and polyacrylamide. Preferably at least 25 % by weight of gelatin is present in the binder.

Preferred assemblies of the present invention comprise a mixture of lithium or zinc acrylate, Methylene Blue or New Methylene Blue, Compound A, B or C, dispersed in gelatin or a mixture of gelatin and another water-soluble binder for example polyvinyl pyrrolidone.

Other components which may be optionally present in the assembly of the present invention include surfactants such as alkyl sulphates, alkylarylsulphonates, polyalkylated phenols and other surfactants well-known in the literature; inhibitors may be present to ensure dark stability of the coated compositions, examples being hydroquinone, p-methoxyphenol, or t-butyl catechol.

Humectants may be present in order to allow better control over the moisture content of the coated layer during the necessary pre-exposure moisture activation step and these may include ethylene glycol, glycerol, trimethylolpropane and other polyhydroxy compounds as well as other compounds known in the art.

Thus there is provided in the present invention photopolymerisable compositions which can be used to prepare assemblies from which holograms can be prepared. Other images such as relief images can also be prepared from the photosensitive assemblies. Compounds of formula I the use of which is the novel feature of the compositions are essentially non-volatile and thus enable the preparation of coated assemblies with lower tackiness and better storage life than assemblies which comprise polymerisation initiators used in the prior art.

For example, it is known to use triethanolamine as a photopolymerisation initiator (C.S. Hsia Chen, J. Polymer Science, A. Volume 3, p. 1107 [1965)] in photopolymerisable compositions, but owing to the volatility of triethanolamine, coatings containing this compound have poor shelf life and are tacky. The compounds of formula I enable coatings to be prepared which are substantially dry to the touch and, owing to their lower volatility of the claimed substances, are more stable towards storage. Fast photopolymerisations may be obtained with these compounds. Additionally the compounds may be advantageously coated from a binder composition containing gelatin and supercoated with a non-photosensitive gelatin layer to improve handling.

The compositions of the present invention are compatible with gelatin and other water-soluble binders commonly used in photographic elements and may be dispersed in such binder solutions and the dispersion

may be coated by a various coating techniques employed in the coating of photographic gelatino silver halide materials. For example the coating may be carried out by doctor bar, slot, cascade, curtain or dip methods.

The coated assemblies may be stored essentially unchanged for several months under low moisture, low temperature conditions. Before exposure the coatings may then simply be activated in a controlled humidity environment, whereupon sufficient moisture is absorbed to enable the photopolymerisation to occur on light exposure.

Exposure may be to white light or light of selected wavelengths, and the compositions of the present invention are especially suitable for exposure to lasers.

However it has been found that improvements in apparent speed may be achieved when a laser exposure is followed by an overall exposure to white light: this has the effect of 'fixing' the holographic image and shortens the necessary laser exposure by up to 1 minute.

The following Examples will serve to illustrate the invention.

Example I

1. Preparation of Photosensitive Assembly Using Compound A

A solution of lithium acrylate was first prepared by adding freshly distilled acrylic acid (1.25 g) to a cooled solution of lithium hydroxide monohydrate (0.67 g) in water (3.50 g). To this solution was added 0.003 g p-methoxyphenol as inhibitor. This solution was then mixed with 3.76 g of a 30 % weight/weight aqueous solution of polyvinylpyrrolidone (40,000 MW) and gelatin (in equal weight proportions). Finally in the dark, the above was mixed with a solution comprising compound A, 0.24 g, New Methylene Blue (3 mg in 0.5 g water) and propan-2-ol (2.7 g).

Within 1 hour the solution was coated under green light conditions on the thin polyester subbed photographic base strips. The coatings had a 'wet' thickness of 100 µm. The coatings were allowed to dry for 30 minutes under a stream of air. At this stage a supercoat of a 5 % wt/wt aqueous gelatin solution was applied and again allowed to dry.

Coatings were stored in the dark at 23 % RH and 19°C until required.

2. Preparation of a hologram from the above prepared assembly

A 25 mW HeNe laser operating at 633 nm was used for the holographic exposures. The optical lay-out used is shown in the accompanying figure.

In this figure the numbers designate the following:

1. 25 mW HeNe laser
2. x 10 microscope objective (25 µm pinhole)
3. Plano-convex lens (focal length 300 mm)
4. Surface silvered mirror
5. Photosensitive member
6. 20W halogen spot light
7. Spatial filters
8. The object
9. Vibration isolated table.

A Denisyuk mode was employed for exposure, with the object 8 (a polished metal disc) approximately 1 mm beneath the photosensitive coating 5. A halogen spot light was fixed 40 cm above the object for post exposure flooding.

Coated assemblies were first placed in a humidifying atmosphere at 65 % RH for 1 hour prior to exposure.

Laser Exposures of 2, 10, 20, 60 and 300 seconds were given. Each coating was given a flood exposure of 180 seconds over half its area, the other half was masked and thus received only the laser exposure. The exposed assemblies were processed at 20° C by placing them in a water bath for 30 seconds. this was followed by placing them in a bath of propan-2-ol. The assemblies were then dried in a stream of cold air, followed by a stream of warm air for 1 minute.

The holograms were laminated with self adhesive clear plastic film after being dried. Holograms were obtained with all exposure times, but those at 2 seconds exposure were no fully stable. In each case, and particularly where shorter laser exposures had been given, the flood exposed area showed a brighter, more stable holographic image. Holograms obtained at 300 seconds exposure were red. Those obtained at 10, 20 and 60 seconds exposure was used, green.

Holograms prepared with shorter exposure (10 seconds) showed some tendency to shift towards the green over a period of six months. Those at 60 seconds and 300 seconds however maintained their original colour.

Brightest holograms were obtained at 10, 20 and 60 second exposures.

Example II

Comparative Examples

Preparation of assemblies sensitive to white light from compounds of present invention and triethanolamine

The compounds of the invention (compounds A, B and C) were coated in the same formulation used in Example I, using 0.24 g of A, B or C and as a control sample, 0.24 g of triethanolamine. The 'wet' thickness of the coating was 100 µm. Samples were dried as before. The sample coated using triethanolamine was tacky and less easily handled than those using compounds A, B and C.

The coated assemblies were humidified for 1 hour at 65 % RH and 20°C before exposing through a mask to a 75 W tungsten lamp, provided with a filter to remove the UV component of the light, placed at 20 cm from the coating. Thermocouples were attached to coated and uncoated areas.

On exposure, the temperature of the coating rose rapidly and the colour of the dye was simultaneously discharged. The initial rates of temperature increase and the maximum differential in temperature (between coated and uncoated areas) were as follows:

| | Temperature Increase [°C/sec] | Max Temperature Differential [°C] |
|---|---|---|
| Compound | | |
| A | 13.2 | 3.0 |
| B | 3.2 | 2.4 |
| C | 16.6 | 11.6 |
| Triethanolamine | 2.7 | 1.7 |

Coatings incorporating compounds A, B and C also bleached more rapidly than the sample containing triethanolamine.

The above exposed assemblies showed well developed differential solubility between exposed and unexposed areas, when washed in solvents such as propan-2-ol and acetone.

The above results show that photosensitive assemblies containing compounds of the formula (1) give marked improvements in rates of photopolymerisation and hence of sensitivity to white light exposure.

**Claims**

1. A photopolymerisable composition which comprises a water-soluble non-volatile ethylenically unsaturated monomer and a combination of a compound of the formula

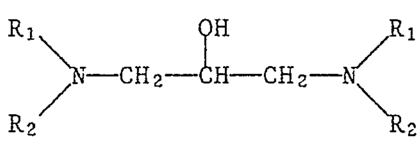

(1)

where $R_1$ is hydrogen or an alkyl group having 1 to 4 carbon atoms or a group of the formula

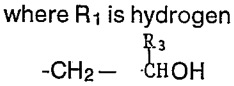

(2)

where $R_3$ is hydrogen or an alkyl group having 1 to 4 carbon atoms and $R_2$ is also a group of formula (2) and a dye, which combination on exposure to light is capable of initiating free radical polymerisation of said ethylenically unsaturated monomer.

2. A photopolymerisable composition according to claim 1 where the compound of the formula (1) is compound A of formula

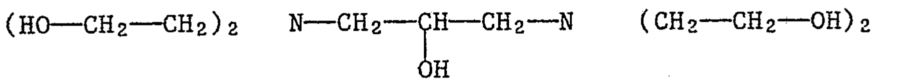 ,

compound B of the formula

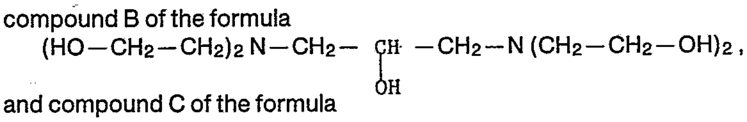

and compound C of the formula

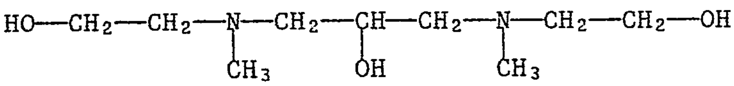 .

3. A photopolymerisable composition according to claim 1 wherein the ethylenically unsaturated monomer is a metal salt of acrylic or methacrylic acid.

4. A photopolymerisable composition according to claim 3 wherein the ethylenically unsaturated monomer is lithium or zinc acrylate.

5. A photopolymerisable composition according to claim 1 wherein the dye capable of initiating free radical polymerisation in the presence of a compound of formula (1) is riboflavin, Rose Bengal, eosin, erythythrosin, Methylene Blue or New Methylene Blue.

6. The use of a compound of the formula

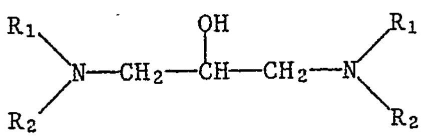 (1)

where $R_1$ is hydrogen or an alkyl group having 1 to 4 carbon atoms or a group of the formula

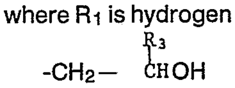 (2)

where $R_3$ is hydrogen or an alkyl group having 1 to 4 carbon atoms and $R_2$ is also a group of formula (2) as a polymerisation initiating agent in combination with a sensitising dye.

7. The use according to claim 6 where the compound of formula (1) is compound A of formula

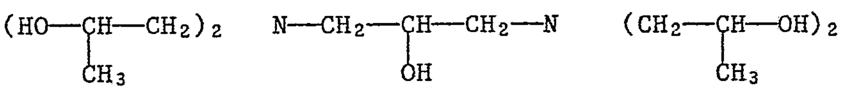 ,

compound B of the formula

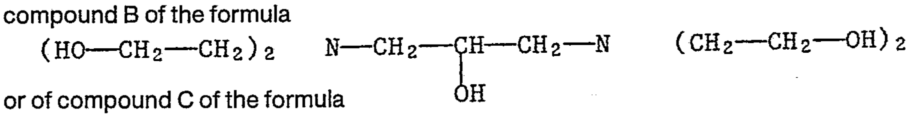 ,

or of compound C of the formula

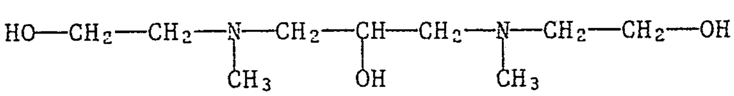 .

8. A photopolymerisable composition which comprises a water-soluble non-volatile ethylenically unsaturated monomer and a combination of a compound of formula (1) or of compound A, B or C as defined in either claim 1 or claim 2 and a dye which combination on exposure to light is capable of initiating free radical polymerisation of the ethylenically unsaturated monomer.

9. A photopolymerisable composition according to claim 8 wherein the ethylenically unsaturated monomer is a metal salt of acrylic or methacrylic acid.

10. A photopolymerisable composition according to claim 9 wherein the ethylenically unsaturated

monomer is lithium or zinc acrylate.

11. A photopolymerisable composition according to claim 8 wherein the dye capable of initiating free radical polymerisation in the presence of a compound of formula (1) is riboflavin, Rose Bengal, eosin, erythythrosin, Methylene Blue or New Methylene Blue.

12. An assembly for the preparation of a hologram which comprises a transparent supporting base on which is coated a polymerisable composition as claimed in claim 8 which has been dispersed in a hydrophilic water-swellable binder.

13. An assembly according to claim 12 wherein the hydrophilic water-swellable binder is gelatin or a binder which comprises at least 25 % by weight of gelatin.

14. A process for the preparation of a hologram which comprises holographically exposing and then processing an assembly as claimed in claim 12.